# EUROPEAN PATENT APPLICATION

(11) **EP 2 854 488 A1**
(43) Date of publication of application: **01.04.2015**
(21) Application number: 14184315.1
(22) Date of filing: 10.09.2014
(51) Int. Cl.: H05K 1/02, H05K 1/16

(54) **Reducing far end crosstalk in single ended interconnects and buses**

(30) Priority: 26.09.2013 US 201314037826
(71) Applicant: Intel Corporation, Santa Clara, CA 95054 (US)
(72) Inventor: Shibayama, Raul, 45086 Zapopan (MX); Lai, Mauro, Tacoma, WA 98407 (US); Kunze, Richard, Woodinville, WA 98072 (US); Peterson, Nicholas, San Jose, CA 95120 (US); Lizalde, Carlos, 44340 Guadalajara (MX); Xiao, Kai, University Place, WA 98467 (US)
(74) Representative: Hufton, David Alan

(57) **Abstract**

Inductive coupling arising between adjacent vias in interconnect technologies (commonly associated with printed circuit boards or package) can be combatted through the addition of metal plates to vias. The plates generate capacitive coupling that can compensate for the inductive crosstalk normally generated between vias in printed circuit boards or packages. When the added plates of two neighboring vias overlap with each other, a capacitive coupling is generated. By balancing the inductive coupling with capacitive coupling, an effective reduction of far end crosstalk may be obtained.

## Description

### Background

This relates generally to the reduction of far end crosstalk in single ended interconnects and buses.

Crosstalk is inductive coupling between adjacent vias. Far end crosstalk is crosstalk or interference, between two signal pairs of an interconnect or bus, measured on the opposite end of a cable from the interfering transmitter. Single ended interconnects and buses use a ground and one signal conductor as part of an interconnect or bus.

Crosstalk is a key limiting factor for high speed signaling in actual platform technology. To achieve acceptable levels of crosstalk, conductor spacing and/or isolation are normally implemented. This spacing results is larger form factors and/or reduction of effective transfer rate density. As a result, product size and/or performance may be compromised.

Single ended interconnects or buses may be used to connect memories to motherboards, for example including double data rate dynamic random access memory (DDR) 2 and 3 as well as synchronous memory interface 2 (SMI2), as an example.

### Brief Description Of The Drawings

Some embodiments are described with respect to the following figures:
Figure 1 is an enlarged cross-sectional depiction of one embodiment in connection with a single-ended interconnect;
Figure 2 is a perspective view of a SMI2 interconnect application according to one embodiment;
Figure 3 is a perspective view of an embodiment using a single-ended bus according to one embodiment;
Figure 4 is a perspective view of a single-ended SMI2 bus according to one embodiment;
Figure 5 is a perspective view of routings according to one embodiment; and
Figure 6 is a schematic depiction for one embodiment.

### Detailed Description

Inductive coupling arising between adjacent vias in bus or interconnect technologies (commonly associated with printed circuit boards or package) can be combatted through the addition of metal plates to vias. The plates generate capacitive coupling that can compensate for the inductive crosstalk normally generated between vias in printed circuit boards or packages. When the added plates of two neighboring vias overlap with each other, a capacitive coupling is generated. By balancing the inductive coupling with capacitive coupling, an effective reduction of far end crosstalk may be obtained.

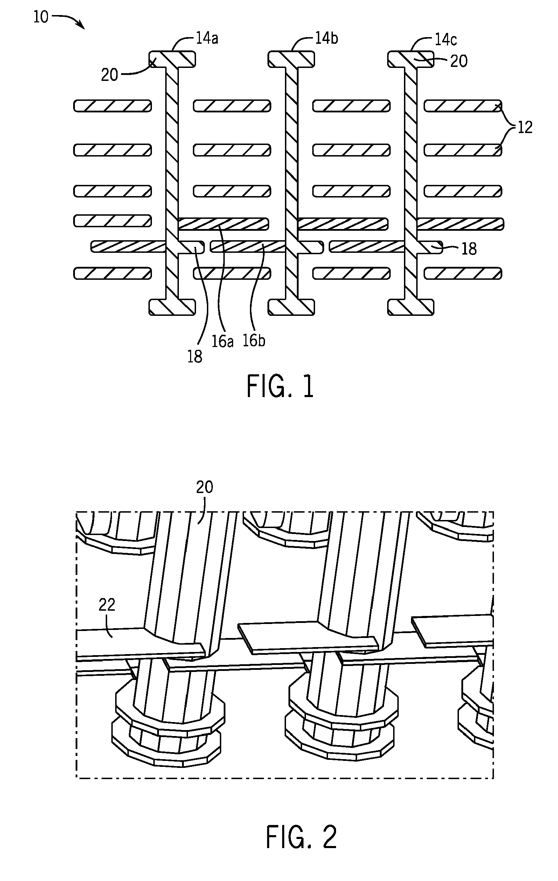

A printed circuit board or package 10, shown in Figure 1, may include a plurality of metallization layers 12 through which pass a plurality of vias 14. The via 14a may get crosstalk from its neighbor 14b and likewise the via 14b may get crosstalk from the via 14a. To combat the crosstalk, capacitive coupling may be created by forming plate capacitors from overlapping metallizations or plaques 16a and 16b. These plaques 16 may be situated adjacent the via output tabs 18 and relatively further away from via inputs 20. The plaques add capacitive coupling that compensates for the inductive crosstalk generated in vias, hence reducing far end crosstalk (FEXT).

The use of the capacitors may have the effect of increasing near end crosstalk (NEXT) but this effect is tolerable, since far end crosstalk tends to be far more important.

With careful design, capacitive and inductive coupling can be balanced, resulting in an effective reduction of far end crosstalk. One reference plane may be cut to make room for one of the plates. However the plates can also be moved to different printed circuit board (PCB) layers to avoid the routing reference plane cut.

Thus, while the capacitors are shown proximate to the signal output, they can be formed anywhere along the length of the vias. The capacitors may be positioned to avoid the need to cut a reference plane or to avoid creating undesired coupling, for example, with a metallization.

Each plate may be defined in an existing metallization. One of the two plates per via may be formed in the same metallization layer as a tab 18 but electrically isolated from that tab 18.

A more specific example, in connection with a synchronous memory interface 2 (SMI2) connector via, is shown in Figure 2. In this case, parallel, spaced plates 22 may be added to the vias 20. The plates may be elongate, aligned with one another, extending in the direction of adjacent vias, with each plate wrapping partly around the via (e.g., about 90° in the plane of the metallization) and extending away from the via transversely so as to be juxtaposed, parallel to and spaced slightly from the corresponding plate extending in the opposite direction from the next adjacent via.

Thus, each via may have a lower plate extending in one direction, namely to the right in the figure and another plate slightly spaced above and extending to the left. Each plate interacts and creates capacitive coupling with a plate coupled to an adjacent via.

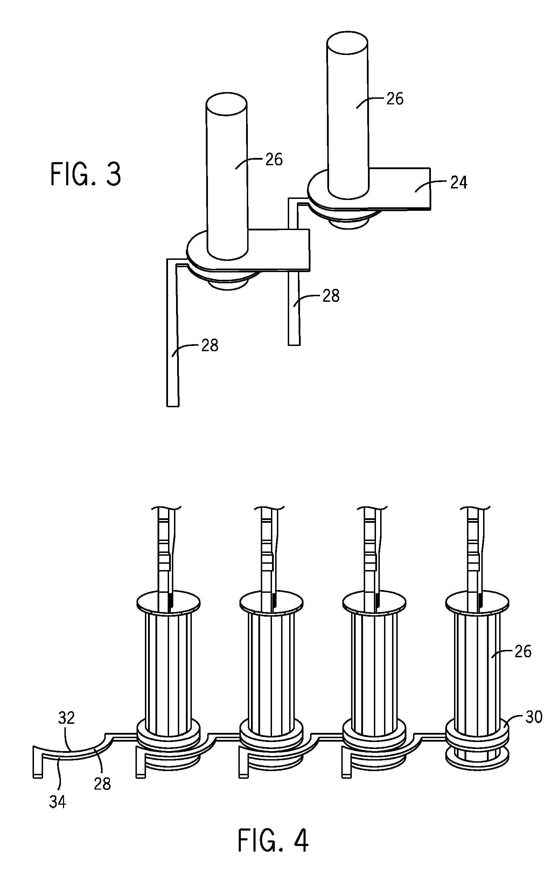

Figure 3 shows an application with single ended buses. In this case, capacitive coupling is again added to overcome inductive coupling between adjacent vias. Thus, the introduction of routing to via pad capacitive coupling reduces far end crosstalk between adjacent bit lanes.

Capacitive coupling balances the unavoidable inductive crosstalk existing between neighboring vias, reducing far end crosstalk. Particularly, a pad 24 may be formed around each via 26. The pad may totally encircle the via to form a capacitor with an input line or trace 28 to an adjacent via. If each via has such a pad, capacitive coupling may be created between a pad 24 of one via and an input line or trace 28 of an adjacent via to overcome the inductive coupling between each adjacent pair of vias.

Figure 4 shows a corresponding application in SMI2 designed bus, commonly used in DDR3 and DDR4. A motherboard stackup may be 93 mils, with 16 layers, that correspond to a typical Brickland platform processor family product application available from Intel Corporation. A generally annular pad 30 may surround or encircle each via 26 proximate to its input trace 28. Then a modified routing 32 may be formed which extends from one via over to a different via, extending in a semi-annular shape 34 in juxtaposition to and parallel to the added via pad 30 and then extending outwardly away from the via, in a typical routing concept.

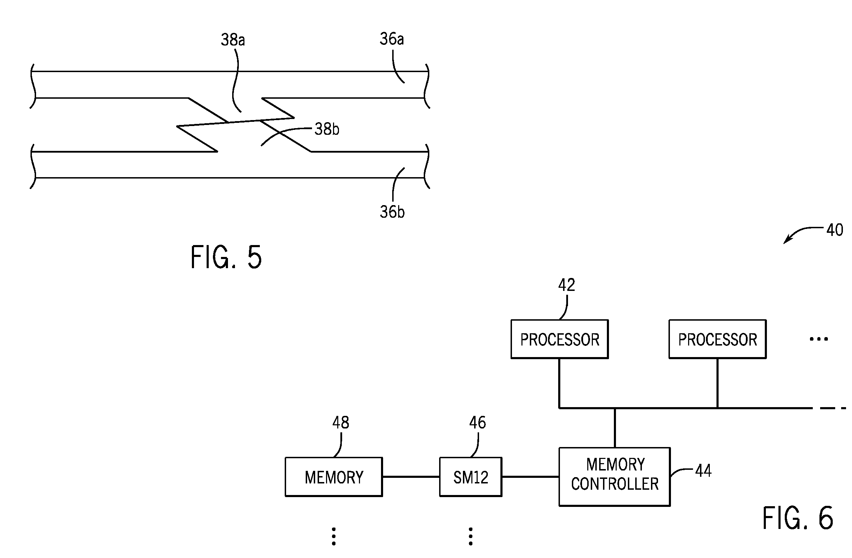

Referring to Figure 5, a capacitor is formed between two adjacent routings. The same techniques can be used to form a capacitor between adjacent pins, traces, metallizations, or solder balls and solder pads. The routings 36a and 36b may be in different metallization layers in one embodiment. The routing 36a may have a plate or extending tab 38a formed along its length. Similarly the routing 36b may have a plate or extending tab 38b also formed along its length. The tabs 38a and 38b overlap, are parallel to one another but spaced apart so as to form a capacitor between the two tabs 38a and 38b. Any number of such capacitors can be formed along the length of a routing as needed to overcome inductive crosstalk.

In some instances, plates that form the capacitor may be formed integrally with the conductor as is the case in Figure 5. In other cases, the plates that form the capacitor may be formed in layers such as metallization layers that are transverse to the conductor for example as shown in connection with Figures 1 and 2. In other cases, the metallization may be a totally separate part from the conductor as is the case in Figures 1-4.

The size of the plates may be adjusted to create capacitance to counteract any inductive coupling. However, smaller plates may be used when necessary, for example because of the close spacing between conductors. In such case, more plates may be provided along the length of the conductors in order to generate the desired amount of capacitance.

Generally, the plates may be made of the same material as the corresponding conductors. However in other embodiments, the plates and the conductors may be made of different material. In some cases, material may be provided between the plates to provide an advantageous dielectric constant.

While depicted plates are planar and either parallel or transverse to the conductors, in other cases, they can be other shapes.

In some cases, the plates may be formed at the same time as the conductors and in other cases, they may be formed separately from those conductors and joined to them as needed. This joining may be the result of active attachment processes such as soldering and may also be the result of simply causing the metals to be in contact in a molten state.

The metallizations, shown for example in Figure 2, may be formed in different orientations relative to but still perpendicular to the length of the vias. For example the metallizations may be rotated 90° in one embodiment. In such case, the metallizations or plates may be attached on spaced the part portions of the vias in order to create the desired plate to plate spacing.

A system 40, shown in Figure 6, may be any processor-based device including a cellular telephone, a laptop computer, a desktop computer, a tablet, a game, or a television to mention some examples. The system 40 may include any number of processors 42, in this case coupled in parallel. The processors 42 may be coupled to a memory controller 44. The memory controller 44 in turn may be connected via SMI2, interconnect or bus 46 to a memory module 48. For example the memory module 48 may be a DDR3 or a DDR4 memory module. The memory controller may be coupled to many interconnects and many memory modules, as indicated in Figure 6.

While embodiments have been described wherein one plate of a capacitor is formed on two adjacent vias, more than one plate can be formed along the extent of each via, forming a plurality of capacitors along the length of the vias.

Via to via capacitors are described with respect to Figures 1 and 2. Via to routing capacitors are described with respect to Figures 3 and 4. A routing to routing capacitor is shown in Figure 5. Similarly, local capacitors may be used to address solder ball inductive crosstalk.

The following clauses and/or examples pertain to further embodiments:
One example embodiment may be a method comprising reducing far end crosstalk by forming a capacitor that counteracts inductive crosstalk between adjacent conductors. The method may also include forming said capacitor by forming one of two plates on each of two adjacent vias. The method may also include forming the capacitor in a single ended bus or interconnect. The method may also include forming the capacitor between a via and a routing. The method may also include forming the capacitor between adjacent routings. The method may also include forming plates of said capacitors in different metallization layers. The method may also include forming an annular plate on a via transverse to the via length and causing a routing on another via to extend parallel to but spaced from said plate. The method may also include forming an annular segment in said routing to follow said annular plate.

Another example embodiment may be an apparatus comprising a pair of substantially parallel conductors positioned so as to be subject to far end crosstalk, and a capacitor including a plate connected to each of said conductors, said capacitor to counteract far end cross talk. The apparatus may include wherein said conductors are vias. The apparatus may include a single ended bus formed of said conductors. The apparatus may include a single ended interconnect formed from said conductors. The apparatus may include wherein one of said conductors is a via and the other conductor is a routing. The apparatus may include wherein said conductors are routings. The apparatus may include wherein said conductors are formed in metallization layers. The apparatus may include wherein said plates are formed in metallization layers. The apparatus may include one of said plates being an annular plate, one of said conductors being a via, said annular plate contacting said via, extending transverse to a length of the via. The apparatus may include the other conductor being a routing extending parallel, but spaced from, said annular plate. The apparatus may include said routing includes an annular segment that extends along, but spaced from, said annular plate.

In another example embodiment may be a system comprising a processor, a memory controller coupled to said processor, and a single ended connector coupled to said memory controller, said connector including a pair of substantially parallel conductors positioned so as to be subject to far end crosstalk, and a capacitor including a plate connected to each of said conductors, said capacitor to counteract far end cross talk. The system may include wherein said connector is an interconnect. The system may include wherein said connector is a bus. The system may include a memory coupled to said connector. The system may include wherein said conductors are vias. The system may include wherein said apparatus includes a single ended bus formed of said conductors. The system may include wherein one of said conductors is a via and the other conductor is a routing. The system may include wherein said conductors are routings. The system may include wherein said conductors are formed in metallization layers. The system may include wherein said plates are formed in metallization layers.

References throughout this specification to "one embodiment" or "an embodiment" mean that a particular feature, structure, or characteristic described in connection with the embodiment is included in at least one implementation encompassed within the present disclosure. Thus, appearances of the phrase "one embodiment" or "in an embodiment" are not necessarily referring to the same embodiment. Furthermore, the particular features, structures, or characteristics may be instituted in other suitable forms other than the particular embodiment illustrated and all such forms may be encompassed within the claims of the present application.

While a limited number of embodiments have been described, those skilled in the art will appreciate numerous modifications and variations therefrom. It is intended that the appended claims cover all such modifications and variations as fall within the true spirit and scope of this disclosure.

## Claims

1. A method comprising:
reducing far end crosstalk by forming a capacitor that counteracts inductive crosstalk between adjacent conductors.

2. The method of claim 1 including forming said capacitor by forming one of two plates on each of two adjacent vias.

3. The method of claim 2 including forming the capacitor in a single ended bus or interconnect.

4. The method of claim 1 including forming the capacitor between a via and a routing.

5. The method of claim 1 including forming the capacitor between adjacent routings.

6. The method of claim 1 including forming plates of said capacitors in different metallization layers.

7. The method of claim 1 including forming an annular plate on a via transverse to the via length and causing a routing on another via to extend parallel to but spaced from said plate.

8. The method of claim 7 including forming an annular segment in said routing to follow said annular plate.

9. An apparatus comprising:
a pair of substantially parallel conductors positioned so as to be subject to far end crosstalk; and
a capacitor including a plate connected to each of said conductors, said capacitor to counteract far end cross talk.

10. The apparatus of claim 9 wherein said conductors are vias.

11. The apparatus of claim 10 wherein said apparatus includes a single ended bus formed of said conductors.

12. The apparatus of claim 10 wherein said apparatus includes a single ended interconnect formed from said conductors.

13. The apparatus of claim 9 wherein one of said conductors is a via and the other conductor is a routing.

14. The apparatus of claim 9 wherein said conductors are routings.

15. The apparatus of claim 9 wherein said conductors are formed in metallization layers.
